# EUROPEAN PATENT APPLICATION

(11) **EP 4 044 223 A1**
(43) Date of publication of application: **17.08.2022**
(21) Application number: 20887970.0
(22) Date of filing: 30.10.2020
(51) Int. Cl.: H01L 23/473, G06F 1/20, H05K 7/20

(54) **COOLING SYSTEM AND ELECTRONIC DEVICE**

(30) Priority: 13.11.2019 JP 2019205336
(71) Applicant: NEC Platforms, Ltd., Kanagawa 213-8511 (JP)
(72) Inventor: OCHIAI, Syoji, Kawasaki-shi, Kanagawa 213-8511 (JP)
(74) Representative: Vossius & Partner Patentanwälte Rechtsanwälte mbB
(86) International application number: PCT/JP2020/040858
(87) International publication number: WO 2021/095568

(57) **Abstract**

A cooling system includes a cooling member including a flow path of a cooling medium configured to cool a heat generating member, a supply side joint provided at a supply side tube and connected to one end of the flow path, a discharge side joint provided at a discharge side tube and connected to another end of the flow path, connection portions respectively provided in the supply side joint and the discharge side joint and connected to the cooling member, connected portions which are respectively formed at both end portions of the flow path and to which the connection portions are connected, and rotation prevention portions configured to prevent the connection portions and the connected portions from rotating relative to each other.

## Description

### TECHNICAL FIELD

The present invention relates to a cooling system and an electronic device.

### BACKGROUND ART

Various electronic devices house a plurality of electronic components in a housing. A liquid cooling scheme is adopted in which the electronic components having high heat generating property among the plurality of electronic components housed in the housing are cooled by a liquid cooling medium.

For example, Patent Document 1 discloses a configuration including a liquid-cooled structure (cooling member) for cooling a heat generating component (heat generating member) of an electronic subsystem (module) provided in a housing.

### Prior Art Document

### Patent Document

Patent Document 1: Published Japanese Translation No. 2015-501489 of the PCT International Publication

### SUMMARY OF INVENTION

### Problems to be solved by the Invention

A tube for supplying and discharging the cooling medium is connected to the cooling member disclosed in Patent Document 1.

For example, when the component arrangement in the housing increases in density as the number of electronic components housed in the housing increases, it may be desirable to lay out the tubes so as to suppress interference with other tubes and other electronic components.

In this case, in order to provide the tube in accordance with the layout, it is necessary to align the tube with respect to the cooling member.

However, when the tube is connected to the cooling member as disclosed in Patent Document 1, the tube may rotate around the central axis with respect to the cooling member.

Therefore, it is difficult to align the tube with respect to the cooling member.

An example object of the present invention is to provide a cooling system and an electronic device that solve any of the above-described problems.

### Means for Solving the Problems

A cooling system according to a first example aspect of the present invention is provided with a cooling member including a flow path of a cooling medium configured to cool a heat generating member mounted on a substrate with a rectangular shape in a plan view, a supply side joint provided at an end portion of a supply side tube configured to supply the cooling medium to the flow path and connected to one end of the flow path of the cooling member, a discharge side joint provided at an end portion of a discharge side tube configured to discharge the cooling medium from the flow path and connected to another end of the flow path of the cooling member, connection portions respectively provided in the supply side joint and the discharge side joint and connected to the cooling member, connected portions which are respectively formed at both end portions of the flow path of the cooling member and to which the connection portions of the supply side joint and the discharge side joint are connected, and rotation prevention portions configured to prevent the connection portions and the connected portions from rotating relative to each other in circumferential directions around central axes of the connection portions.

An electronic device according to a second example aspect of the present invention is provided with a housing and the cooling system housed in the housing.

### Example Advantageous Effects of Invention

According to the first example aspect and the second example aspect described above, it is easy to align the tube with respect to the cooling member.

### BRIEF DESCRIPTION OF DRAWINGS

FIG. 1 is a diagram showing a minimum configuration of a cooling system according to a first example embodiment of the present invention.
FIG. 2 is a diagram showing a minimum configuration of an electronic device according to a second example embodiment of the present invention.
FIG. 3 is a perspective view showing a schematic configuration of an electronic device according to a third example embodiment of the present invention.
FIG. 4 is a plan view showing side modules on a lower stage side in the electronic device according to the third example embodiment of the present invention.
FIG. 5 is a plan view showing side modules on an upper stage side and a center module in the electronic device according to the third example embodiment of the present invention.
FIG. 6 is a plan view mainly showing a branch tube portion provided in the side modules on the upper stage side and the center module in the electronic device according to the third example embodiment of the present invention.
FIG. 7 is a perspective development view showing the center module provided in a cooling system for the electronic device according to the third example embodiment of the present invention, and a supply side joint and a discharge side joint connected to the center module.
FIG. 8 is a plan view showing part of the cooling system according to the third example embodiment of the present invention.
FIG. 9 is a perspective view of a joint member constituting the supply side joint and the discharge side joint provided in the cooling system according to the third example embodiment of the present invention.
FIG. 10 is a plan view showing a modification example of the cooling system according to the third example embodiment of the present invention.

### EXAMPLE EMBODIMENT

A plurality of example embodiments of the present invention will be described below with reference to the drawings.

### [First Example embodiment]

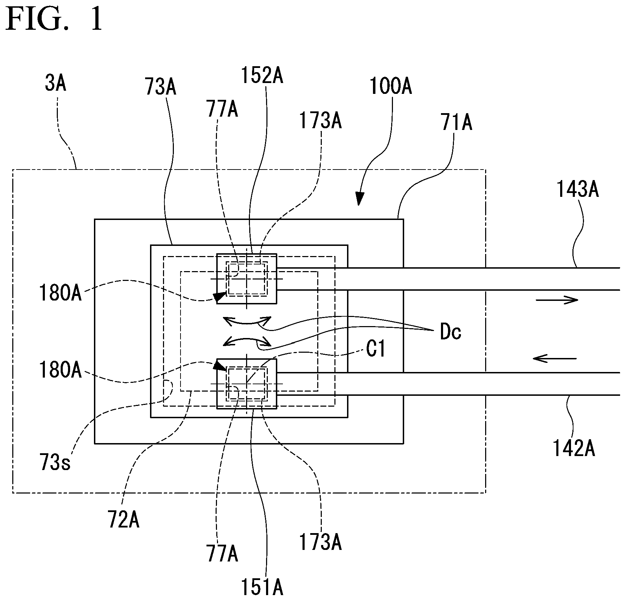

FIG. 1 is a diagram showing a minimum configuration of a cooling system according to the present example embodiment.

As shown in this figure, a cooling system 100A needs only to be provided with at least a cooling member 73A, a supply side joint 151A, a discharge side joint 152A, connection portions 173A, connected portions 77A, and rotation prevention portions 180A. The cooling system 100A is provided in a housing 3A.

The cooling member 73A cools a heat generating member 72A mounted on a substrate 71A having a rectangular shape in a plan view. The cooling member 73A is provided with a flow path 73s of a cooling medium.

The supply side joint 151A is provided at the end portion of a supply side tube 142A that supplies the cooling medium to the flow path 73s of the cooling member 73A. The supply side joint 151A is connected to one end of the flow path 73s of the cooling member 73A.

The discharge side joint 152A is provided at the end portion of a discharge side tube 143A that discharges the cooling medium from the flow path 73s of the cooling member 73A. The discharge side joint 152A is connected to the other end of the flow path 73s of the cooling member 73A.

The connection portion 173A is provided in each of the supply side joint 151A and the discharge side joint 152A. The connection portions 173A are connected to the cooling member 73A.

The connected portions 77A are formed at both end portions of the flow path 73s of the cooling member 73A. The connection portions 173A of the supply side joint 151A and the discharge side joint 152A are connected to the connected portions 77A.

The rotation prevention portion 180A prevents the connection portion 173A and the connected portion 77A from rotating relative to each other in the circumferential direction Dc around a central axis C1 of the connection portion 173A.

In such a cooling system 100A, the cooling medium flows from the supply side tube 142A into the flow path 73s of the cooling member 73A via the supply side joint 151A connected to one end portion of the flow path 73s. The cooling member 73A is cooled by the cooling medium flowed into the flow path 73s. As a result, the heat generating member 72A mounted on the substrate 71A is cooled by the cooling member 73A. The cooling medium in the flow path 73s is discharged from the discharge side joint 152A connected to the other end portion of the flow path 73s through the discharge side tube 143A.

In this configuration, the rotation prevention portions 180A suppress the relative rotation of the connection portions 173A of the supply side joint 151A and the discharge side joint 152A and the connected portions 77A formed at both end portions of the flow path 73s of the cooling member 73A in the circumferential directions Dc around the central axes C1 of the connection portions 173A. As a result, when the connection portions 173A of the supply side joint 151A and the discharge side joint 152A are connected to the connected portions 77A, it is possible to prevent the orientation in the circumferential directions Dc of the connection portions 173A from being displaced with respect to the connected portions 77A.

Therefore, it is easy to align the supply side tube 142A and the discharge side tube 143A with respect to the cooling member 73A.

Furthermore, when the supply side tube 142A and the discharge side tube 143A can be aligned, it is possible to prevent the supply side tube 142A and the discharge side tube 143A from interfering with other tubes and electronic components.

### [Second Example embodiment]

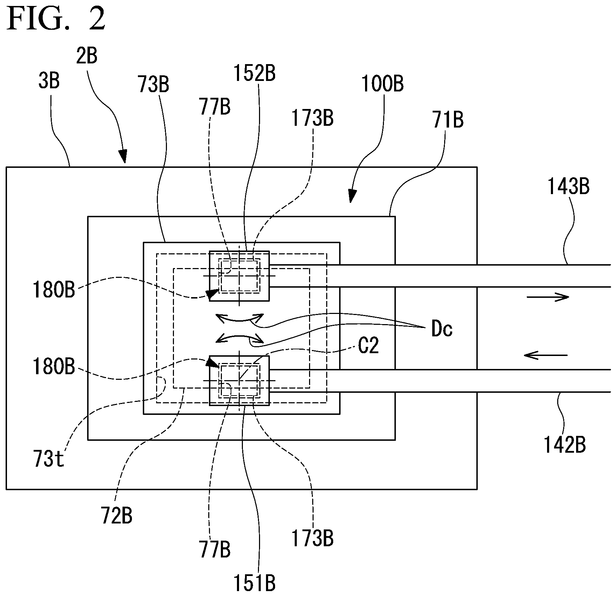

FIG. 2 is a diagram showing a minimum configuration of an electronic device according to the present example embodiment.

As shown in this figure, an electronic device 2B needs only to be provided with at least a housing 3B and a cooling system 100B housed in the housing 3B. The cooling system 100B is provided with a cooling member 73B, a supply side joint 151B, a discharge side joint 152B, connection portions 173B, connected portions 77B, and rotation prevention portions 180B.

The cooling member 73B cools a heat generating member 72B mounted on a substrate 71B having a rectangular shape in a plan view. The cooling member 73B is provided with a flow path 73t of a cooling medium.

The supply side joint 151B is provided at the end portion of a supply side tube 142B that supplies the cooling medium to the flow path 73t of the cooling member 73B. The supply side joint 151B is connected to one end of the flow path 73t of the cooling member 73B.

The discharge side joint 152B is provided at the end portion of a discharge side tube 143B that discharges the cooling medium from the flow path 73t of the cooling member 73B. The discharge side joint 152B is connected to the other end of the flow path 73t of the cooling member 73B.

The connection portion 173B is provided in each of the supply side joint 151B and the discharge side joint 152B. The connection portion 173B is connected to the cooling member 73B.

The connected portions 77B are formed at both end portions of the flow path 73t of the cooling member 73B. The connection portions 173B of the supply side joint 151B and the discharge side joint 152B are connected to the connected portions 77B.

The rotation prevention portion 180B prevents the connection portion 173B and the connected portion 77B from rotating relative to each other in the circumferential direction Dc around a central axis C2 of the connection portion 173B.

In such a cooling system 100B, the cooling medium flows from the supply side tube 142B into the flow path 73t of the cooling member 73B via the supply side joint 151B connected to one end portion of the flow path 73t. The cooling member 73B is cooled by the cooling medium flowed into the flow path 73t. As a result, the heat generating member 72B mounted on the substrate 71B is cooled by the cooling member 73B. The cooling medium in the flow path 73t is discharged from the discharge side joint 152B connected to the other end portion of the flow path 73t through the discharge side tube 143B.

In this configuration, the rotation prevention portions 180B suppress the relative rotation of the connection portions 173B of the supply side joint 151B and the discharge side joint 152B and the connected portions 77B formed at both end portions of the flow path 73t of the cooling member 73B in the circumferential directions Dc around the central axes C2 of the connection portions 173B. As a result, when the connection portions 173B of the supply side joint 151B and the discharge side joint 152B are connected to the connected portions 77B, it is possible to prevent the orientation in the circumferential directions Dc of the connection portions 173B from being displaced with respect to the connected portions 77B.

Therefore, it is easy to align the supply side tube 142B and the discharge side tube 143B with respect to the cooling member 73B.

Furthermore, when the supply side tube 142B and the discharge side tube 143B can be aligned, it is possible to prevent the supply side tube 142B and the discharge side tube 143B from interfering with other tubes and electronic components.

### [Third Example embodiment]

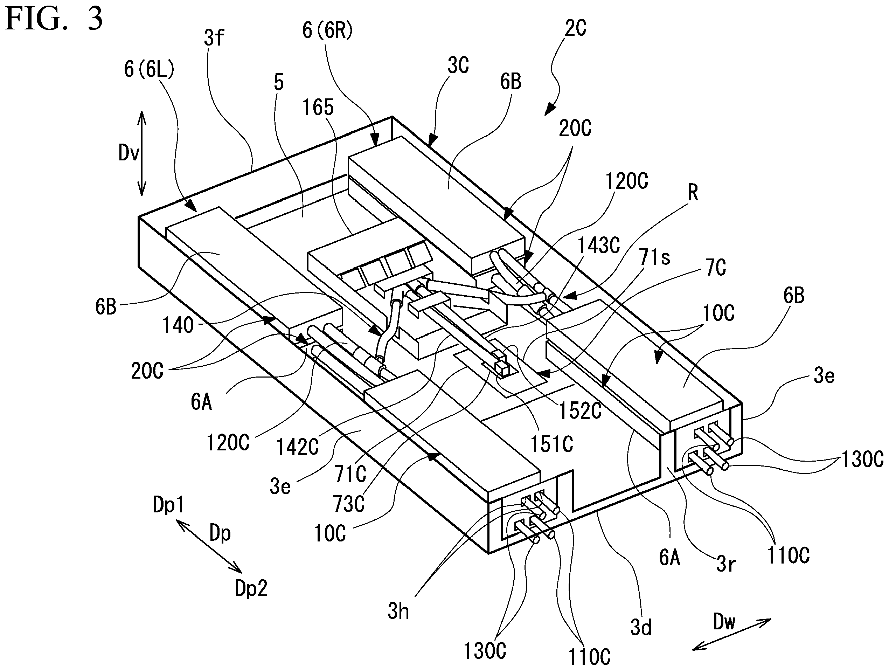

FIG. 3 is a perspective view showing a schematic configuration of an electronic device according to the present example embodiment.

### (Overall Configuration of Server)

As shown in this figure, a server (electronic device) 2C is provided with a housing 3C, a main substrate 5, side modules 6, and a center module 7C. One or more servers 2C are housed in a server rack (not shown) to form a server apparatus (not shown). The server 2C is provided so as to be inserted and removed from the server rack (not shown) along the horizontal direction. In the following description, the insertion and removal direction of the server 2C with respect to the server rack is referred to as a depth direction Dp. In addition, the direction orthogonal to the depth direction Dp in the horizontal plane is referred to as a width direction Dw, and the direction orthogonal to the depth direction Dp and the width direction Dw is referred to as a vertical direction Dv.

### (Housing)

The housing 3C is formed in a rectangular shape having a long side in the depth direction Dp when viewed from the vertical direction Dv in a plan view. The housing 3C is provided with at least a bottom plate 3d provided along a horizontal plane and a pair of side plates 3e rising upward from both sides of the bottom plate 3d in the width direction Dw. The housing 3C is provided with a rear panel 3r rising upward from the bottom plate 3d on the second side Dp2 of the bottom plate 3d in the depth direction Dp. Furthermore, the housing 3C may be provided with a front panel 3f on the first side Dp1 of the bottom plate 3d in the depth direction Dp.

### (Main Substrate)

The main substrate 5, the side modules 6, and the center module 7C are housed in the housing 3C.

The main substrate 5 has a flat plate shape and is disposed along the bottom plate 3d of the housing 3C. The main substrate 5 is disposed at a central portion in the housing 3C in the width direction Dw.

### (Side Module)

The side modules 6 are disposed on both sides of the main substrate 5 in the width direction Dw in the housing 3C. In each side module 6, a lower stage side module portion 6A and an upper stage side module portion 6B are provided so as to be laminated in the vertical direction Dv. Each of the lower stage side module portion 6A and the upper stage side module portion 6B is provided with a first module 10C and a second module 20C.

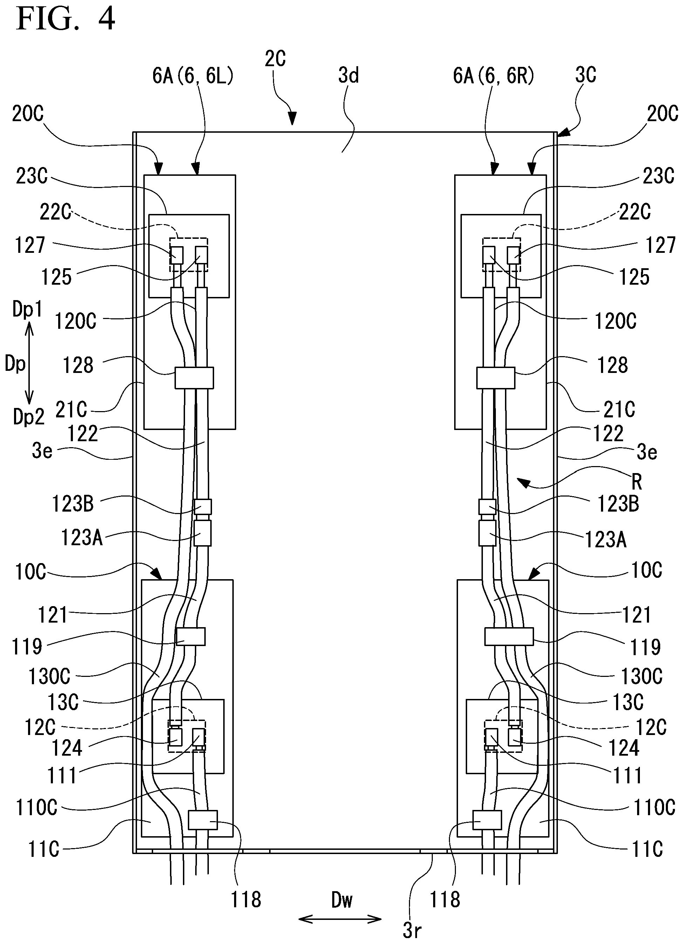

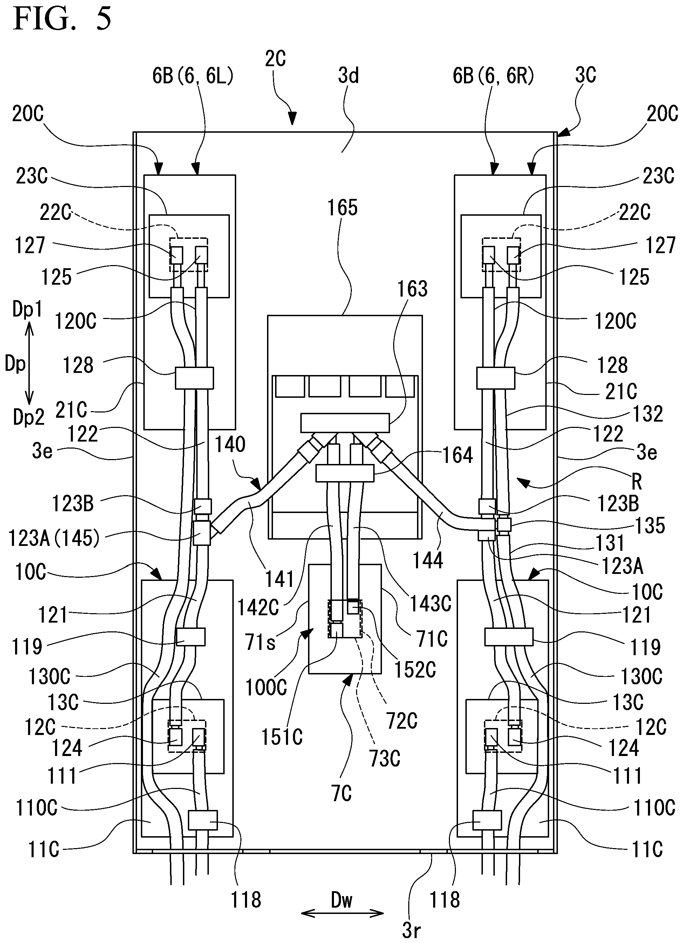

FIG. 4 is a plan view showing side modules on a lower stage side in the electronic device according to the present example embodiment. FIG. 5 is a plan view showing side modules on an upper stage side and a center module in the electronic device according to the present example embodiment.

As shown in these figures, the first module 10C is provided in the housing 3C in each of the lower stage side module portion 6A and the upper stage side module portion 6B. The first module 10C is provided with a side module substrate 11C, a side module central processing unit (CPU) 12C, and a side module cooling member 13C.

The side module substrate 11C has a flat plate shape and is disposed along a horizontal plane. The side module CPU 12C is mounted on the surface of the side module substrate 11C. The side module CPU 12C functions as a processor that executes predetermined processing. The side module cooling member 13C is provided so as to be laminated on the side module CPU 12C. The side module cooling member 13C is made of a metal material and has, for example, a rectangular parallelepiped shape. A space (not shown) into which the cooling medium flows is formed inside the side module cooling member 13C. A refrigerant inlet (not shown) and a refrigerant outlet (not shown) communicating with the space (not shown) are formed on the upper surface of the side module cooling member 13C.

The second module 20C is provided in the housing 3C at an interval from the first module 10C on the first side Dp1 of the housing 3C in the depth direction Dp. The second module 20C has the same configuration as the first module 10C and is provided with a side module substrate 21C, a side module CPU 22C, and a side module cooling member 23C.

The side module substrate 21C has a flat plate shape and is disposed along a horizontal plane. The side module CPU 22C is mounted on the surface of the side module substrate 21C. The side module CPU 22C functions as a processor that executes predetermined processing. The side module cooling member 23C is provided so as to be laminated on the side module CPU 22C. The side module cooling member 23C is made of a metal material and has, for example, a rectangular parallelepiped shape. A space (not shown) into which the cooling medium flows is formed inside the side module cooling member 23C. A refrigerant inlet (not shown) and a refrigerant outlet (not shown) communicating with the space (not shown) are formed on the upper surface of the side module cooling member 23C.

### (Center Module)

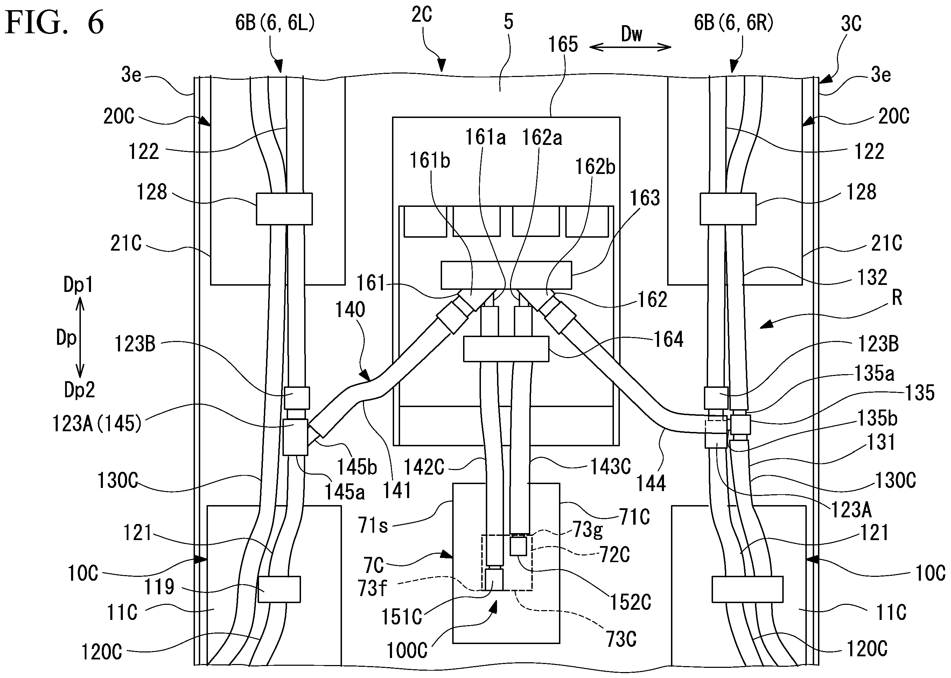

FIG. 6 is a plan view mainly showing a branch tube portion provided in the side modules on the upper stage side and the center module in the electronic device according to the present example embodiment.

As shown in FIG. 3, the center module 7C is disposed above the main substrate 5 at intervals from each side module 6 in the width direction Dw. The center module 7C is disposed at substantially the same height as the upper stage side module portions 6B in the vertical direction Dv. As shown in FIGS. 5 and 6, the center module 7C is provided with a substrate 71C, a CPU (heat generating member) 72C, and a cooling member 73C.

The substrate 71C has a flat plate shape and is disposed along a horizontal plane in parallel with the bottom plate 3d of the housing 3C. The substrate 71C has a rectangular shape viewed from the vertical direction Dv in a plan view. The substrate 71C has a rectangular shape in a plan view. The substrate 71C is disposed so that sides 71s in the long side direction are along the depth direction Dp. The substrate 71C is supported on the main substrate 5 or the bottom plate 3d via a support member (not shown).

The CPU 72C is mounted on the substrate 71C. The CPU 72C functions as a processor that executes predetermined processing in cooperation with the side module CPUs 12C and 22C of the plurality of first modules 10C and second modules 20C.

The cooling member 73C is provided so as to be laminated on the CPU 72C. The cooling member 73C cools the CPU 72C mounted on the substrate 71C. The cooling member 73C is made of a metal material and has, for example, a rectangular parallelepiped shape. The cooling member 73C has a rectangular shape when viewed from the vertical direction Dv intersecting the surface of the substrate 71C, and the four sides thereof are disposed along the depth direction Dp and the width direction Dw.

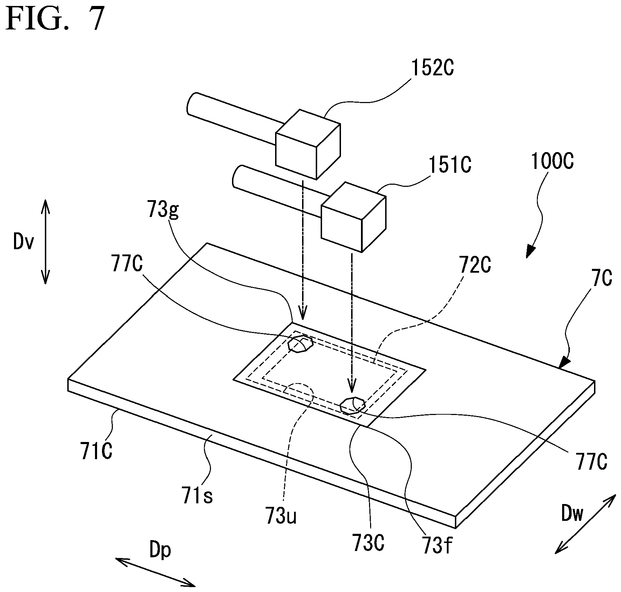

FIG. 7 is a perspective development view showing the center module provided in the cooling system of the electronic device of the present example embodiment, and the supply side joint and the discharge side joint connected to the center module.

As shown in this figure, a flow path 73u of the cooling medium for cooling the CPU 72C is formed inside the cooling member 73C. For example, the flow path 73u is continuously formed in a labyrinth-like shape, a zigzag-like shape, or the like along a horizontal plane orthogonal to the vertical direction Dv in a region facing the CPU 72C.

A pair of connected portions 77C are formed on the upper surface of the cooling member 73C by opening both end portions of the flow path 73u. In the present example embodiment, the pair of connected portions 77C are disposed on the upper surface of the cooling member 73C at diagonal corner portions 73f and 73g. That is, the pair of connected portions 77C are diagonally disposed on the corner portions 73f and 73g of the cooling member 73C. In other words, the pair of connected portions 77C are disposed at different positions from each other in the cooling member 73C in the depth direction Dp and the width direction Dw.

### (Cooling System)

As shown in FIGS. 3 to 5, the server 2C is provided with a cooling system R. The cooling system R forms a flow path of a cooling medium for cooling the side module cooling members 13C of the first modules 10C, the side module cooling members 23C of the second modules 20C, and the cooling member 73C of the center module 7C. The cooling system R is provided with upstream side tubes 110C, downstream side tubes 120C, discharge tubes 130C, and a branch tube portion 140 (refer to FIG. 5).

### (Upstream Side Tube and Downstream Side Tube)

The upstream side tube 110C supplies a cooling medium made of a liquid such as water to the side module cooling member 13C of the first module 10C from the outside. The upstream side tube 110C is inserted from the outside to the inside of the housing 3C through a tube insertion opening 3h (refer to FIG. 3) formed in the rear panel 3r of the housing 3C. As shown in FIGS. 4 and 5, the upstream side tube 110C extends in the depth direction Dp in the housing 3C. The upstream side tube 110C is connected to the side module cooling member 13C of the first module 10C from the second side Dp2 in the depth direction Dp. An end portion of the upstream side tube 110C is connected to the refrigerant inlet (not shown) of the side module cooling member 13C of the first module 10C via an L-shaped connection joint 111. The upstream side tube 110C is fixed to the side module substrate 11C of the first module 10C by a holder member 118 between the connection joint 111 and the portion inserted into the tube insertion opening 3h.

The downstream side tube 120C supplies the cooling medium passed through the side module cooling member 13C of the first module 10C to the side module cooling member 23C of the second module 20C. The downstream side tube 120C is provided so as to extend in the depth direction Dp between the side module cooling member 13C of the first module 10C and the side module cooling member 23C of the second module 20C. One end of the downstream side tube 120C is connected to the side module cooling member 13C of the first module 10C, and the other end of the downstream side tube 120C is connected to the side module cooling member 23C of the second module 20C. The downstream side tube 120C is provided with a first downstream side tube 121, a second downstream side tube 122, and joints 123A and 123B.

One end portion of the first downstream side tube 121 is connected to a refrigerant outlet (not shown) of the side module cooling member 13C of the first module 10C via an L-shaped connection joint 124. The connection joint 124 is connected to the side module cooling member 13C at a position spaced apart from the connection joint 111 of the upstream side tube 110C in the width direction Dw. The joint 123A is provided at the other end portion of the first downstream side tube 121. The first downstream side tube 121 is fixed to the side module substrate 11C of the first module 10C by a holder member 119 between the connection joint 124 and the joint 123A.

One end portion of the second downstream side tube 122 is connected to the refrigerant inlet (not shown) of the side module cooling member 23C of the second module 20C via an L-shaped connection joint 125. The joint 123B is provided at the other end portion of the second downstream side tube 122. The second downstream side tube 122 is fixed to the side module substrate 21C of the second module 20C by a holder member 128 between the connection joint 125 and the joint 123B.

The joints 123A and 123B are detachably connected to each other. As a result, the joints 123A and 123B detachably connect the first downstream side tube 121 to the second downstream side tube 122.

### (Discharge Tube)

The discharge tube 130C discharges the cooling medium passed through the first module 10C and the second module 20C. The discharge tube 130C is inserted into the housing 3C from the outside of the housing 3C through the tube insertion opening 3h formed in the rear panel 3r of the housing 3C. The discharge tube 130C extends in the depth direction Dp in the housing 3C. The discharge tube 130C is connected to the side module cooling member 23C of the second module 20C from the second side Dp2 in the depth direction Dp. The end portion of the discharge tube 130C is connected to the refrigerant outlet (not shown) of the side module cooling member 23C of the second module 20C via an L-shaped connection joint 127. The connection joint 127 is connected to the side module cooling member 23C at a position spaced apart from the connection joint 125 of the second downstream side tube 122 in the width direction Dw. The discharge tube 130C is fixed to the side module substrate 21C of the second module 20C by the holder member 128 together with the second downstream side tube 122 on the first module 10C side with respect to the connection joint 127.

### (Branch Tube Portion and Cooling System)

The branch tube portion 140 takes out part of the cooling medium from the upper stage side module portion 6B of the side module 6L on one side in the width direction Dw (e.g., left side in FIGS. 5 and 6) in the housing 3C and supplies the part of the cooling medium that has been taken out to a cooling system 100C of the center module 7C. The branch tube portion 140 sends the cooling medium passed through the cooling system 100C to the upper stage side module portion 6B of the side module 6R on the other side in the width direction Dw (e.g., right side in FIGS. 5 and 6) in the housing 3C. The branch tube portion 140 is provided with a branch tube 141, a supply side tube 142C, a discharge side tube 143C, and a merging tube 144.

The branch tube 141 is provided so as to branch from the downstream side tube 120C. Therefore, a branch joint 145 is used for the joint 123A on the first downstream side tube 121 side. As shown in FIG. 6, the branch joint 145 includes a main tube portion 145a and a branch tube portion 145b. The main tube portion 145a has a tubular shape continuous in the depth direction Dp and is detachably connected to the joint 123B. The branch tube portion 145b branches from the main tube portion 145a and diagonally extends inward in the width direction Dw of the housing 3C toward the first side Dp1 in the depth direction Dp. One end portion of the branch tube 141 is connected to the branch tube portion 145b. The branch tube 141 extends diagonally from the branch joint 145 to the first side Dp1 in the depth direction Dp inward in the width direction Dw of the housing 3C.

The supply side tube 142C supplies a cooling medium to the flow path 73u of the cooling member 73C. The supply side tube 142C extends in the depth direction Dp along the surface of the substrate 71C.

The branch tube 141 and the supply side tube 142C are connected to each other via a joint member 161. The joint member 161 integrally includes a first connection portion 161a and a second connection portion 161b.

The first connection portion 161a has a tubular shape and extends in the tube axial direction (depth direction Dp) of the supply side tube 142C. The other end of the supply side tube 142C is connected to the first connection portion 161a. The second connection portion 161b has a tubular shape and extends in the tube axial direction (diagonal direction intersecting the width direction Dw and the depth direction Dp) of the branch tube 141. The other end portion of the branch tube 141 is connected to the second connection portion 161b. The first connection portion 161a and the second connection portion 161b communicate with each other.

The discharge side tube 143C discharges the cooling medium from the flow path 73u of the cooling member 73C. The discharge side tube 143C extends in the depth direction Dp along the surface of the substrate 71C.

The merging tube 144 is connected to the discharge side tube 143C via a joint member 162. The merging tube 144 extends diagonally from the joint member 162 to the second side Dp2 in the depth direction Dp toward the outside of the housing 3C in the width direction Dw.

The joint member 162 integrally includes a first connection portion 162a and a second connection portion 162b. The first connection portion 162a has a tubular shape and extends in the tube axial direction (depth direction Dp) of the discharge side tube 143C. The other end of the discharge side tube 143C is connected to the first connection portion 162a. The second connection portion 162b has a tubular shape and extends in the tube axial direction (diagonal direction intersecting the width direction Dw and the depth direction Dp) of the merging tube 144. One end portion of the merging tube 144 is connected to the second connection portion 162b. The first connection portion 162a and the second connection portion 162b communicate with each other. Such a joint member 162 has the same configuration as the joint member 161 and is configured to include common components.

The other end of the merging tube 144 is connected to the discharge tube 130C provided in the upper stage side module portion 6B of the side module 6R on the other side in the width direction Dw via a merging joint 135. The discharge tube 130C provided in the upper stage side module portion 6B of the side module 6R is provided with a first discharge tube 131 on the first module 10C side and a second discharge tube 132 on the second module 20C side. The merging joint 135 is provided between an end portion of the first discharge tube 131 and an end portion of the second discharge tube 132.

The merging joint 135 includes a main tube portion 135a and a branch tube portion 135b. The main tube portion 135a has a tubular shape continuous in the depth direction Dp, and both end portions thereof are connected to the first discharge tube 131 and the second discharge tube 132. The branch tube portion 135b branches from the main tube portion 135a at the intermediate portion of the main tube portion 135a and extends inward in the width direction Dw of the housing 3C. The other end of the merging tube 144 is connected to the branch tube portion 135b.

The above joint member 161 and the joint member 162 are fixed to a joint holder 163. In addition, the supply side tube 142C and the discharge side tube 143C are fixed to a branch tube holder 164 between a supply side joint 151C, a discharge side joint 152C, and the joint members 161 and 162. The joint holder 163 and the branch tube holder 164 are provided on a hood member 165. The hood member 165 is fixed to the main substrate 5.

### (Cooling System of Center Module)

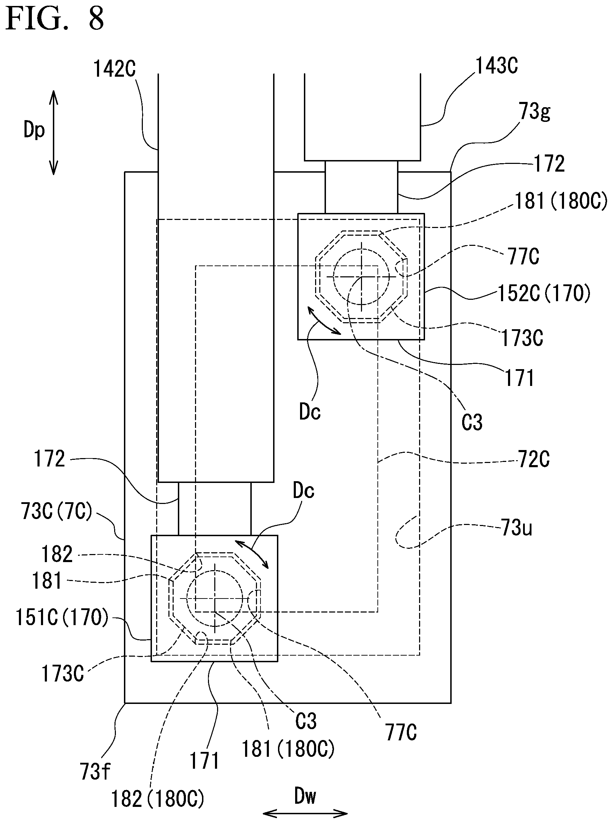

FIG. 8 is a plan view showing part of the cooling system of the present example embodiment.

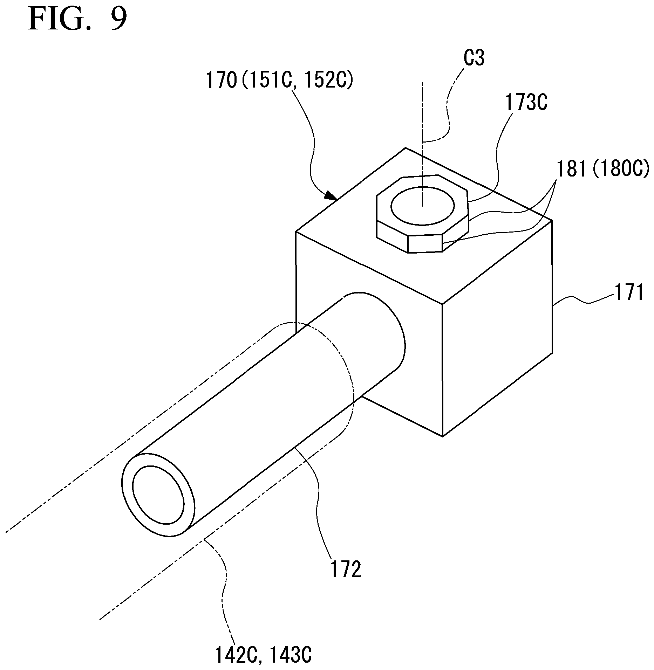

The center module 7C is cooled by the cooling system 100C as below. As shown in FIGS. 7 and 8, the cooling system 100C is provided with the cooling member 73C, the supply side joint 151C, the discharge side joint 152C, connection portions 173C (refer to FIGS. 8 and 9), the connected portions 77C, and rotation prevention portions 180C (refer to FIGS. 8 and 9).

The cooling system 100C is housed in the housing 3C.

The supply side joint 151C is provided at the end portion of the supply side tube 142C. The supply side joint 151C is connected to the connected portion 77C formed at one end of the flow path 73u of the cooling member 73C.

The discharge side joint 152C is provided at the end portion of the discharge side tube 143C. The discharge side joint 152C is connected to the connected portion 77C formed at the other end of the flow path 73u of the cooling member 73C.

Here, as described above, the pair of connected portions 77C are diagonally disposed on the corner portions 73f and 73g of the cooling member 73C. Therefore, the supply side joint 151C and the discharge side joint 152C are provided at different positions from each other in the depth direction Dp along the sides 71s of the substrate 71C. In addition, the supply side joint 151C and the discharge side joint 152C are provided at different positions from each other in the width direction Dw.

### (Joint Member)

FIG. 9 is a perspective view of a joint member constituting a supply side joint and a discharge side joint provided in the cooling system of the present example embodiment.

A joint member 170 as shown below is used for the supply side joint 151C and the discharge side joint 152C. The joint member 170 is L-shaped and integrally includes a joint main body 171, a tube connection portion 172, and a connection portion 173C.

The tube connection portion 172 is connected to the end portion of the supply side tube 142C or the discharge side tube 143C. The tube connection portion 172 has a cylindrical shape and extends from the joint main body 171 in the tube axial direction of the supply side tube 142C and the discharge side tube 143C.

The connection portion 173C is connected to the connected portion 77C of the cooling member 73C. The connection portion 173C has a cylindrical shape and extends from the joint main body 171 in a direction orthogonal to the extending direction of the tube connection portion 172. The connection portion 173C and the tube connection portion 172 communicate with each other in the joint main body 171.

As shown in FIGS. 8 and 9, the cross-sectional shape of the connection portion 173C orthogonal to a central axis C3 along the extending direction from the joint main body 171 is a regular polygonal shape. That is, the connection portion 173C has a regular polygonal columnar outer shape extending in the central axis C3 direction. In the present example embodiment, the connection portion 173C has, for example, a regular octagonal cross-sectional shape. The connection portion 173C having a regular polygonal (regular octagonal) cross-sectional shape in this manner includes a plurality of projection portions 181 in the circumferential direction Dc around the central axis C3. Each projection portion 181 projects outward in the radial direction with respect to the central axis C3.

Each connected portion 77C to which the connection portion 173C is connected is formed by being recessed downward from the upper surface of the cooling member 73C. The connected portion 77C has a regular polygonal cross-sectional shape that complements the shape of the connection portion 173C. In the present example embodiment, the connected portion 77C has, for example, a regular octagonal cross-sectional shape. The connected portion 77C having a regular polygonal (regular octagonal) cross-sectional shape in this manner has a plurality of recessed portions 182 in the circumferential direction Dc around the central axis C3. Each recessed portion 182 is recessed inward in the radial direction with respect to the central axis C3.

The rotation prevention portion 180C prevents the connection portion 173C and the connected portion 77C from rotating relative to each other in the circumferential direction Dc around the central axis C3 of the connection portion 173C. The rotation prevention portion 180C is provided with the plurality of projection portions 181 formed in the connection portion 173C and the plurality of recessed portions 182 formed in the connected portion 77C. In a state in which the connection portion 173C is inserted into the connected portion 77C, the plurality of projection portions 181 of the connection portion 173C and the plurality of recessed portions 182 of the connected portion 77C engage with each other. As a result, it is possible to prevent the connection portion 173C and the connected portion 77C from rotating relative to each other in the circumferential direction Dc around the central axis C3 of the connection portion 173C.

In order to connect the supply side tube 142C or the discharge side tube 143C to the cooling member 73C, the connection portion 173C of the joint member 170 constituting the supply side joint 151C or the discharge side joint 152C is inserted into the connected portion 77C. In this state, the connection portion 173C and the connected portion 77C are joined by, for example, brazing. At this time, prior to brazing the joint member 170 to the cooling member 73C, in order to align the tube axial direction of the supply side tube 142C or the discharge side tube 143C along a predetermined extending direction, the orientation of the joint member 170 around the central axis C3 is aligned with the connected portion 77C. Since the connection portion 173C and the connected portion 77C each have a regular polygonal shape, the connection portion 173C of the joint member 170 is rotated around the central axis C3, and the projection portions 181 and the recessed portions 182 are engaged with each other in an appropriate orientation around the central axis C3.

When the number of corners of the cross-sectional shape of the connection portion 173C and the connected portion 77C is small, the orientation of the connection portion 173C with respect to the connected portion 77C around the central axis C3 is limited. In addition, when the number of corners of the cross-sectional shape of the connection portion 173C and the connected portion 77C is too large, a slip occurs in the circumferential direction Dc between the projection portions 181 and the recessed portions 182 that engage with each other, and the binding force for suppressing the relative rotation of the connection portion 173C and the connected portion 77C in the circumferential direction Dc is reduced. Therefore, it is preferable that the cross-sectional shape of the connection portion 173C and the connected portion 77C is, for example, a regular quadrangle to a regular decagonal shape. Furthermore, it is particularly preferable that the cross-sectional shape of the connection portion 173C and the connected portion 77C is a regular octagon.

### (Flow of Cooling Medium)

In such a cooling system R, the cooling medium flows in each of the lower stage side module portion 6A and the upper stage side module portion 6B of the side modules 6 (6L, 6R) on both sides in the width direction Dw as follows.

The cooling medium flows into the upstream side tube 110C from a cooling medium supply tube (not shown) provided outside the housing 3C. The cooling medium flows into the space (not shown) from the refrigerant inlet (not shown) of the side module cooling member 13C of the first module 10C through the upstream side tube 110C and cools the side module cooling member 13C. As a result, the heat of the side module CPU 12C on which the side module cooling member 13C is laminated is taken away, and the temperature rise of the side module CPU 12C is suppressed. The cooling medium that flows out from the space (not shown) of the side module cooling member 13C through the refrigerant outlet (not shown) flows into the space (not shown) from the refrigerant inlet (not shown) of the side module cooling member 23C of the second module 20C via the downstream side tube 120C and cools the side module cooling member 23C. As a result, the heat of the side module CPU 22C of the second module 20C on which the side module cooling member 23C is laminated is taken away, and the temperature rise of the side module CPU 22C is suppressed. In this manner, the cooling medium passed through the first module 10C and the second module 20C flows from the space (not shown) of the side module cooling member 23C through the refrigerant outlet (not shown) into the discharge tube 130C. The cooling medium is discharged to a cooling medium discharge tube (not shown) provided outside the housing 3C through the discharge tube 130C.

In addition, in the upper stage side module portion 6B of the side module 6L on one side in the width direction Dw, part of the cooling medium flowed into the first downstream side tube 121 of the downstream side tube 120C via the side module cooling member 13C of the first module 10C is diverted to the branch tube portion 140 through the branch joint 145. In the branch joint 145, the cooling medium flowing through the first downstream side tube 121 is divided to the main tube portion 145a and the branch tube portion 145b. The cooling medium flowed into the branch tube portion 145b flows into the flow path 73u of the cooling member 73C from the supply side joint 151C connected to one end portion of the flow path 73u through the branch tube 141, the joint member 161, and the supply side tube 142C. The cooling member 73C is cooled by the cooling medium flowed into the flow path 73u. As a result, the heat of the CPU 72C mounted on the substrate 71C is taken away, and the temperature rise of the CPU 72C is suppressed. The cooling medium in the flow path 73u flows out to the discharge side tube 143C via the discharge side joint 152C connected to the other end portion of the flow path 73u. The cooling medium flows into the branch tube portion 135b of the merging joint 135 through the discharge side tube 143C, the joint member 162, and the merging tube 144. The cooling medium merges into the flow of the cooling medium in the main tube portion 135a from the branch tube portion 135b and flows into the first discharge tube 131 of the discharge tube 130C. The cooling medium is discharged to a cooling medium discharge tube (not shown) provided outside the housing 3C through the discharge tube 130C provided in the upper stage side module portion 6B of the side module 6R on the other side in the width direction Dw.

In the cooling system 100C, the rotation prevention portion 180C suppresses the relative rotation of the connection portion 173C and the connected portion 77C in the circumferential direction Dc around the central axis C3 of the connection portion 173C.

In this configuration, when the connection portion 173C is connected to the connected portion 77C of the cooling member 73C, it is possible to prevent the orientation of the connection portion 173C from being displaced in the circumferential direction Dc.

Therefore, it is easy to align the supply side tube 142C and the discharge side tube 143C with the cooling member 73C.

For example, when joining a joint provided at the end portion of a tube to a cooling member by, for example, brazing, it is necessary to align the orientation of the connection portion with the connected portion in the circumferential direction around the central axis of the connection portion.

Even in such a case, according to the present example embodiment, as described above, it is easy to align the orientation of the connection portion 173C with the connected portion 77C in the circumferential direction Dc around the central axis C3 of the connection portion 173C. Therefore, the supply side joint 151C and the discharge side joint 152C can be easily joined to the cooling member 73C by, for example, brazing.

Furthermore, when the supply side tube 142C and the discharge side tube 143C can be aligned, it is possible to prevent the supply side tube 142C and the discharge side tube 143C from interfering with other tubes and electronic components.

In the cooling system 100C, the supply side joint 151C and the discharge side joint 152C are provided at different positions from each other in the direction along the sides 71s of the substrate 71C.

In this configuration, it is possible to prevent the supply side tube 142C having the supply side joint 151C provided at the end portion and the discharge side tube 143C having the discharge side joint 152C provided at the end portion from interfering with each other.

In the cooling system 100C, the connected portions 77C are formed diagonally on the corner portions 73f and 73g of the cooling member 73C.

In this configuration, by connecting the connection portions 173C to the connected portions 77C formed diagonally on the corner portions 73f and 73g of the cooling member 73C, the supply side joint 151C and the discharge side joint 152C are diagonally disposed on the corner portions 73f and 73g of the cooling member 73C. As a result, it is possible to prevent the supply side tube 142C having the supply side joint 151C provided at the end portion and the discharge side tube 143C having the discharge side joint 152C provided at the end portion from interfering with each other.

In the cooling system 100C, the supply side tube 142C and the discharge side tube 143C extend along the surface of the substrate 71C.

When the supply side tube 142C and the discharge side tube 143C extend along the surface of the substrate 71C, interference between the supply side tube 142C and the discharge side tube 143C is likely to occur, but the orientation of the connection portion 173C in the circumferential direction Dc is easily aligned by the rotation prevention portion 180C.

As a result, it is possible to prevent the supply side tube 142C and the discharge side tube 143C having the supply side joint 151C and the discharge side joint 152C provided at the end portions from interfering with other tubes and electronic components in the housing 3C.

In the cooling system 100C, the rotation prevention portion 180C includes the projection portions 181 formed in the connection portion 173C and the recessed portions 182 formed in the connected portion 77C.

In this configuration, by engaging the projection portions 181 and the recessed portions 182, the orientation of the connection portion 173C in the circumferential direction Dc can be easily aligned with the connected portion 77C.

In the cooling system 100C, the cross-sectional shape orthogonal to the central axis C3 of the connection portion 173C and the connected portion 77C is a regular polygonal shape.

In this configuration, the connection portion 173C and the connected portion 77C having a regular polygonal cross-sectional shape engage with each other, so that the orientation of the connection portion 173C in the circumferential direction Dc can be easily aligned with the connected portion 77C. In addition, by rotating the connection portion 173C around the central axis C3 with respect to the connected portion 77C, the supply side joint 151C and the discharge side joint 152C can be provided in accordance with an angle selected from a plurality of angles around the central axis C3. As a result, it is possible to easily set the direction in which the supply side tube 142C and the discharge side tube 143C having the supply side joint 151C and the discharge side joint 152C provided at the end portions extend.

The server 2C is provided with the housing 3C and the above cooling system 100C.

In this configuration, by providing the cooling system 100C, it is easy to align the supply side tube 142C and the discharge side tube 143C with the cooling member 73C.

Furthermore, when the supply side tube 142C and the discharge side tube 143C can be aligned, it is possible to prevent the supply side tube 142C and the discharge side tube 143C from interfering with other tubes and electronic components in the housing 3C.

### (Modification Examples of Example Embodiments)

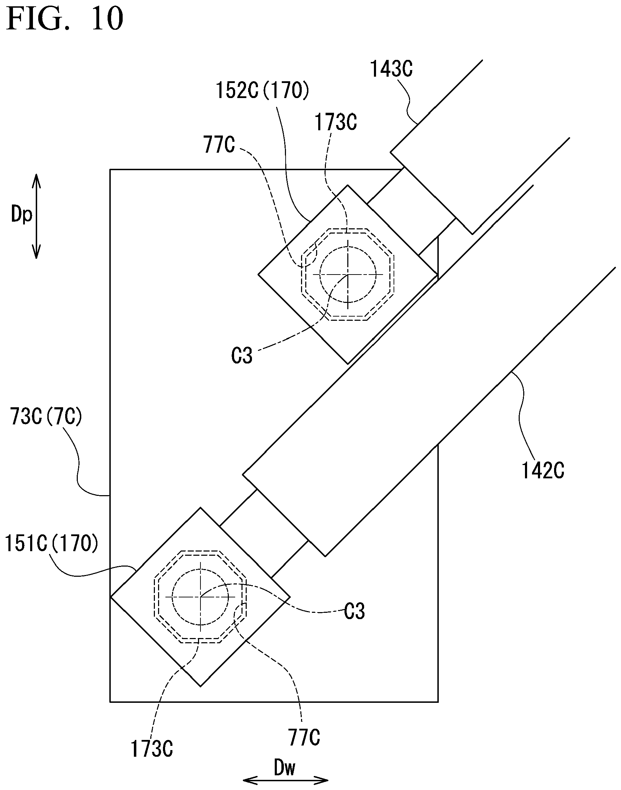

In the third example embodiment, the supply side tube 142C and the discharge side tube 143C extend in the depth direction Dp, but the direction in which the supply side tube 142C and the discharge side tube 143C extend is not limited thereto. For example, as shown in FIG. 10, the supply side tube 142C and the discharge side tube 143C may extend along the surface of the substrate 71C in a direction other than the depth direction Dp. In addition, the supply side tube 142C and the discharge side tube 143C may extend in different directions from each other.

In addition, in the third example embodiment, the center module 7C is provided with the cooling system 100C, but the arrangement of the cooling system 100C is not limited thereto. The first module 10C and/or the second module 20C provided in the housing 3C may be provided with a cooling system 100C having the same configuration.

In addition, in the third example embodiment, as the rotation prevention portion 180C of the cooling system 100C, the projection portions 181 are provided in the connection portion 173C and the recessed portions 182 are provided in the connected portion 77C, but the arrangement of the projection portions 181 and the recessed portions 182 is not limited thereto. The recessed portions 182 may be provided in the connection portion 173C, and the projection portions 181 may be provided in the connected portion 77C. That is, in this case, the connected portion 77C is a protrusion that projects upward from the upper surface of the cooling member 73C. The connection portion 173C is a hole into which the connected portion 77C is inserted.

In addition, in the third example embodiment, the connection portion 173C and the connected portion 77C have a regular polygonal cross-sectional shape, but the cross-sectional shape of the connection portion 173C and the connected portion 77C is not limited thereto. For example, the connection portion 173C and the connected portion 77C may have a cross-sectional gear shape or the like. In addition, for example, a key-shaped projection portion may be provided in part of the connection portion 173C in the circumferential direction Dc, and a keyway-shaped recessed portion may be formed in the connected portion 77C.

In addition, in the third example embodiment, the supply side tube 142C and the discharge side tube 143C are disposed at the same height in the vertical direction Dv, but the arrangement of the supply side tube 142C and the discharge side tube 143C is not limited thereto. The supply side tube 142C and the discharge side tube 143C may be disposed at different heights from each other in the vertical direction Dv. For this purpose, for example, the lengths of the connection portion 173C and the joint main body 171 in the vertical direction Dv may be different between the supply side joint 151C and the discharge side joint 152C. As a result, the heights of the tube connection portions 172 to which the supply side tube 142C and the discharge side tube 143C are connected are different from each other between the supply side joint 151C and the discharge side joint 152C.

Furthermore, in the third example embodiment, the side modules 6 are provided in the housing 3C, but the number, arrangement, configuration, and the like of the first modules 10C and the second modules 20C constituting the side modules 6 can be changed as appropriate. In addition, the server 2C may be configured not to be provided with the side modules 6.

In addition, the applications, component configurations, number of equipment, and the like of the cooling systems 100A to 100C, the electronic device 2B, and the server 2C shown in the first to third example embodiments are not limited at all.

In addition to this, unless it deviates from the gist of the present invention, it is possible to select the configuration described in the above example embodiments and/or change it to another configuration as appropriate.

This application is based upon and claims the benefit of priority from Japanese Patent Application No. 2019-205336, filed November 13, 2019, the disclosure of which is incorporated herein in its entirety by reference.

### INDUSTRIAL APPLICABILITY

The present invention can be applied to, for example, an electronic device provided with a cooling member for cooling a heat generating member. According to the present invention, it is easy to align the tube with respect to the cooling member.

### Description of Reference Signs

2B: Electronic device
2C: Server (electronic device)
3A, 3B, 3C: Housing
71A, 71B, 71C: Substrate
71s: Side
72A, 72B: Heat generating member
72C: CPU (heat generating member)
73A, 73B, 73C: Cooling member
73f, 73g: Corner portion
73s, 73t, 73u: Flow path
77A, 77B, 77C: Connected portion
100A, 100B, 100C: Cooling system
142A, 142B, 142C: Supply side tube
143A, 143B, 143C: Discharge side tube
151A, 151B, 151C: Supply side joint
152A, 152B, 152C: Discharge side joint
173A, 173B, 173C: Connection portion
180A, 180B, 180C: Rotation prevention portion
181: Projection portion
182: Recessed portion
C1, C2, C3: Central axis
Dc: Circumferential direction

## Claims

1. A cooling system comprising:
a cooling member including a flow path of a cooling medium configured to cool a heat generating member mounted on a substrate with a rectangular shape in a plan view;
a supply side joint provided at an end portion of a supply side tube configured to supply the cooling medium to the flow path and connected to one end of the flow path of the cooling member;
a discharge side joint provided at an end portion of a discharge side tube configured to discharge the cooling medium from the flow path and connected to another end of the flow path of the cooling member;
connection portions respectively provided in the supply side joint and the discharge side joint and connected to the cooling member;
connected portions which are respectively formed at both end portions of the flow path of the cooling member and to which the connection portions of the supply side joint and the discharge side joint are connected; and
rotation prevention portions configured to prevent the connection portions and the connected portions from rotating relative to each other in circumferential directions around central axes of the connection portions.

2. The cooling system according to claim 1, wherein the supply side joint and the discharge side joint are provided at different positions from each other in a direction along a side of the substrate.

3. The cooling system according to claim 1 or 2, wherein the cooling member comprises a rectangular shape when viewed from a direction intersecting a surface of the substrate, and
the connected portions are formed diagonally on corner portions of the cooling member.

4. The cooling system according to any one of claims 1 to 3, wherein the supply side tube and the discharge side tube extend along a surface of the substrate.

5. The cooling system according to any one of claims 1 to 4, wherein the rotation prevention portions each comprise:
projection portions formed on one of the connection portions and the connected portions and configured to project outward in a radial direction with respect to the central axes of the connection portions; and
recessed portions formed on the other of the connection portions and the connected portions, recessed inward in the radial direction with respect to the central axes of the connection portions, and configured to engage with the projection portions.

6. The cooling system according to claim 5, wherein the connection portions and the connected portions comprise a regular polygonal cross-sectional shape orthogonal to the central axes of the connection portions.

7. An electronic device comprising:
a housing; and
the cooling system according to any one of claims 1 to 6 housed in the housing.
